# EUROPEAN PATENT APPLICATION

(11) **EP 4 641 225 A1**
(43) Date of publication of application: **29.10.2025**
(21) Application number: 24305624.9
(22) Date of filing: 23.04.2024
(51) Int. Cl.: G01R 31/28, G01R 31/317, G01R 31/3187, G01R 31/3167

(54) **TEST CIRCUIT FOR DETECTING FAULTS OCCURRING IN A FURTHER CIRCUIT**

(71) Applicant: NXP B.V., 5656 AG Eindhoven (NL)
(72) Inventor: Vignasse,, Baptiste François Jean, 31023 Toulouse (FR); Bernon,, Valérie, 31023 Toulouse (FR); Gibas,, Piotr, 5656 AG Eindhoven (NL)
(74) Representative: Schmütz, Christian Klaus Johannes

(57) **Abstract**

A test circuit for detecting faults occurring in a further circuit, the test circuit comprising: a detector block configured to: receive an input signal at least based on an analogue signal output from the further circuit during operation of the further circuit; determine the occurrence of changes in the input signal, and generate a fault signal indicative of a determination of the occurrence of a fault in the further circuit based at least on a predetermined number of the determined changes in the input signal occurring over a first time duration.

## Description

### Field

The present disclosure relates to a test circuit for determining the occurrence of a fault. In particular, the present disclosure relates to a test circuit for determining the occurrence of a fault in a further circuit from which the test circuit receives an analogue signal. It also relates to a method.

### Background

The functional safety standards ISO 26262 and IEC 61508 require the detection of latent faults which are dangerous, as they prevent the safety mechanisms to detect faults. Usually, in the analogue side of semiconductors, this is achieved by performing ABIST (Automatic Built-In Self-Test) at least once per cycle, but such testing is time consuming and the circuitry is large, in addition that in industrial application the system might remain in an on-state for a long time.

Providing self-testing without undue burden presents a challenge.

### Summary

According to a first aspect of the present disclosure there is provided a test circuit for detecting faults occurring in a further circuit, the test circuit comprising:
a detector block configured to:
receive an input signal at least based on an analogue signal output from the further circuit during operation of the further circuit;
determine the occurrence of changes in the input signal, and
generate a fault signal indicative of a determination of the occurrence of a fault in the further circuit based at least on a predetermined number of the determined changes in the input signal occurring over a first time duration.

In one or more embodiments, the test circuit is configured to receive the analogue signal output from one of: a sensor of the further circuit; an actuator of the further circuit; a switch of the further circuit.

In one or more embodiments, the test circuit includes:
a characterisation block configured to receive the analogue signal from the further circuit and, based on the analogue signal, generate a signature signal, wherein the signature signal is indicative of changes in the analogue signal that meet one or more criteria, wherein the input signal to the detector block comprises said signature signal.

In one or more examples, the characterisation block comprises a filter.

In one or more examples, the characterisation block is configured to generate the signature signal based on changes in the analogue signal that are greater than one or more thresholds.

In one or more embodiments, the predetermined number comprises zero and the detector block is configured to generate the fault signal based on when there is an absence of changes in the input signal persisting for the first time duration.

In one or more embodiments, the detector block includes a timer to measure the first time duration and wherein the timer is reset based on each determination of the occurrence of the change in the input signal.

In one or more embodiments, the predetermined number comprises at least one and the detector block is configured to generate the fault signal based on when there are greater than the predetermined number of changes in the input signal occurring over the first time duration.

In one or more embodiments, the predetermined number comprises at least two and the detector block is configured to generate the fault signal when there are less than the predetermined number of changes in the input signal occurring over the first time duration.

In one or more embodiments, the detector block is configured to generate the fault signal indicative of the determination of the occurrence of a fault in the further circuit based on no input signal being received.

In one or more embodiments, the detector block is configured to generate the fault signal indicative of the determination of the occurrence of a fault in the further circuit based on a magnitude of the input signal being greater than a predetermined maximum threshold value.

In one or more embodiments, the detector block is configured to generate the fault signal indicative of the determination of the occurrence of a fault in the further circuit based on a magnitude of the input signal being less than a predetermined minimum threshold value.

In one or more embodiments, the test circuit further comprises an action block configured to generate signalling to control the operation of the further circuit based on generation of the fault signal.

In one or more embodiments, the first time duration comprises a sliding time window.

In one or more examples, the detector block is configured to determine the occurrence of changes in the input signal over a first period of the first time duration, and, determine the occurrence of changes in the input signal over a second period of the first time duration contiguous with the first period.

In one or more embodiments, the first time duration is measured from points in time defined by the operation of the further circuit.

According to a second aspect of the present disclosure there is provided a system comprising the further circuit and the test circuit of any preceding claim, wherein the test circuit comprises a built-in-self-test, BIST, circuit for the further circuit.

According to a third aspect of the present disclosure there is provided a method of determining the occurrence of a fault in a further circuit by a test circuit, the method comprising:
receiving an input signal at least based on an analogue signal output from the further circuit during operation of the further circuit;
determining the occurrence of changes in the input signal, and
generating a fault signal indicative of a determination of the occurrence of a fault in the further circuit based at least on a predetermined number of the determined changes in the input signal occurring over a first time duration.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of a test circuit and a further circuit;
Figure 2 shows an example of an analogue signal from the further circuit and a signature signal derived from the analogue signal; and
Figure 3 shows an example method.

### Detailed Description

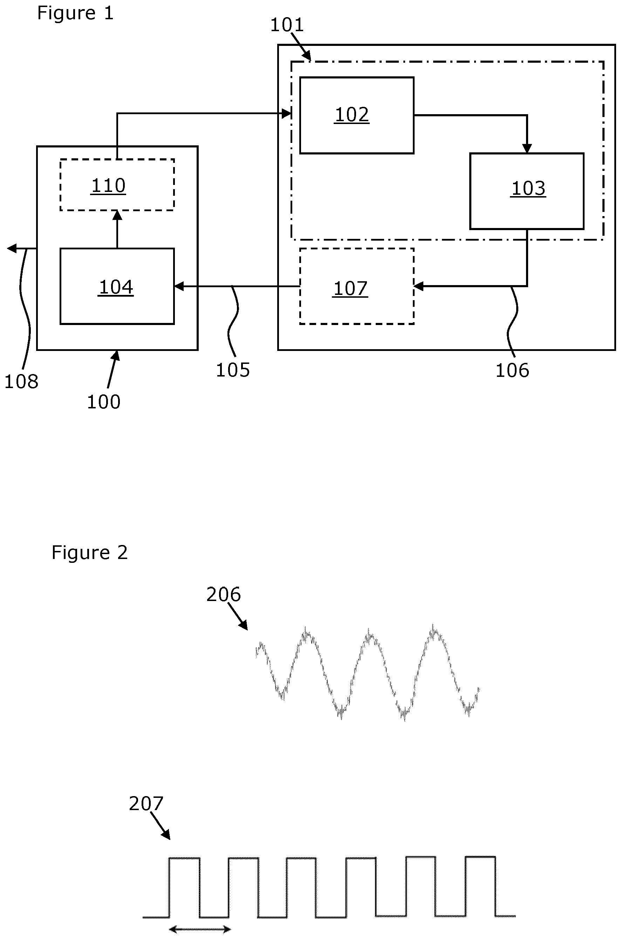

Figure 1 shows an example embodiment of a test circuit for detecting faults in a further circuit by determining the occurrence of unexpected changes or the absence of changes in a signal from the further circuit, wherein that signal from the further circuit is expected to change or oscillate in some way, such as with no fixed frequency.

Figure 1 shows the test circuit 100 for monitoring an output of the further circuit 101. The further circuit may comprise a first block 102 for performing a function. The first block 102 may comprise a controller or other circuitry configured to perform the function. The first block may perform the function using, or receive data for performing the function from, a second block 103. The second block 103 may comprise a sensor, an actuator, one or more switches, or any other circuitry involved in providing the function of the further block 102 and thereby, at least in part, the further circuit 101. In the present example, the output of the second block 103 is expected to change relatively frequently but, potentially, without a predictable pattern. In other embodiments, a different pattern of change may be considered to be typical.

The test circuit 100 is configured to detect faults occurring in the further circuit 101. In the present embodiment, the test circuit is configured to detect faults by monitoring the output, during normal operation, of one or more components of the further circuit 101, namely the second block 103. The test circuit 100 thereby determines the occurrence of potential faults based on monitoring the output.

In summary, the test circuit 100 comprises a detector block 104 configured to receive an input signal 105 comprising an analogue signal 106 that is output from at least part of the further circuit 101 during normal operation of the further circuit, i.e. when it is performing its normal function rather than operating in a test mode. In some examples, which will be described later, the input signal 105 is based on the analogue signal 106, rather than directly comprising the analogue signal 106. In such examples, the analogue signal 106 may be processed by an optional characterisation block 107.

The detector block 104 is configured to determine the occurrence of changes in the input signal 105. The detector block 104 is configured to, if a fault is determined, generate a fault signal 108 indicative of a determination of the occurrence of a fault in the further circuit 101. The generation of the fault signal is based at least on a predetermined number of the determined changes in the input signal occurring over a first time duration. The first time duration may comprise a recent time window, such as a sliding window. The detector block 104 thereby enables the determination of the number of changes in the input signal within a current window of time having the first time duration. Thus, the recent time window is defined relative to a current time. In other examples, the first time duration may be a fixed period of time based on the operation of the further circuit 101, such as being defined relative to a start-up event of the further circuit, prior to a shut down or at any other operationally significant time.

The detector block 104 may be configured to determine when the number of changes that are detected deviate (such as by more than a threshold amount) from a typical, predefined number of changes that are to be expected over the first time duration. In an alternative configuration, the detector block 104 may be configured to determine when the number of changes that are detected meet an atypical, predefined number of changes over the first time duration.

Thus, as an example, should the second block 103 comprise a sensor, if no changes are detected in the analogue output of the sensor 103 that is provided to the detector block 104, then it may be concluded that the state of the sensor 103 is frozen and therefore likely to result in malfunction of the operation(s) performed by the further circuit 101. The detector block 104 may therefore be configured to generate the fault signal. Thus, in such an example the predefined number of changes is set to zero and therefore when no changes are determined to have occurred for a length of time equal to the first time duration, the detector block 104 generates the fault signal. It will be appreciated that this example can apply where the second block 103 comprises circuitry other than a sensor.

The test circuit 100 may therefore advantageously be configured to count changes in the output of components of the further circuit 101 over the first time duration to make a determination of the occurrence of a fault.

The detector block 104 may comprise one or more comparators configured to determine changes in the input signal, such as changes above a predetermined threshold. The detector block 104 may include a counter for counting the number of changes in the first time duration. The detector block 104 may comprise a timer configured to measure the first time duration. Thus, in one example, the timer may be configured to measure the first time duration and, on expiry of the first time duration, reset the counter. The counter may be configured to count changes in the input signal based on the output of a comparator, which is configured to determine changes in the input signal. The detector block may be configured to generate the fault signal if the number of changes counted by the counter exceeds a predetermined number.

In the example of figure 1, the test circuit includes the characterisation block 107 configured to receive the analogue signal 106 from the further circuit 101 and, based on the analogue signal 106, generate a signature signal which is provided as the input signal 105 to the detector block 104. The signature signal is indicative of changes in the analogue signal that meet one or more criteria. Thus, it can be appreciated that the "raw" output from the second block 103 may include noise or other fluctuations that may be considered "changes" in the signal, but those changes are not ones that represent any functional problem with the second block 104. The characterisation block 107 may be configured to process or filter the analogue signal 106 to generate the signature signal which represents a characterisation of functional changes in the analogue signal that can be analysed for abnormalities, or deviation from normality, by the detector block 104.

As an example, the characterisation block 107 may comprise one or more of a lowpass filter, a high-pass filter and a band-pass filter. The filtering may be configured to reduce noise or too fast or too low transients in the analogue signal 106. The characterisation block 107 may comprise one or more comparators configured to detect a low to high transition in the analogue signal based on a first threshold and/or a high to low transition in the analogue signal based on a second threshold. Accordingly, the signature signal may therefore comprise a signal that is indicative of changes in the analogue signal that exceed the first threshold and/or the second threshold and/or without transitions caused by noise or other unintentional transients.

Figure 2 shows an example analogue signal 206 from the further circuit 101. In this example, the analogue signal 206 is substantially sinusoidal with additional noise mixed therein. For the purposes of the detector block 104, the analogue signal 206 may be too noisy for easily identifying a number of changes in the signal. Figure 2 also shows an example of the signature signal 207 generated by the characterisation block 107 that represents the changes in the analogue signal 206 that are considered relevant for making a determination of a fault. Thus, in this example, the characterisation block 107 is configured to generate a signature signal that changes state based on the analogue signal exceeding each of a positive threshold value and a negative threshold value. In other examples, the characterisation block 107 may be configured to generate a signature signal that changes state based on the analogue signal exceeding one of a positive threshold value or negative threshold value (or not exceeding said threshold values if the analogue signal would normally be expected to).

It has been described that the detector block 104 may be configured to generate the fault signal based on the condition of when there is an absence of changes in the input signal persisting for the first time duration. In such an example, the detector block may include a timer to measure the first time duration and wherein the timer is reset based on each determination of the occurrence of the change in the input signal. Thus, the detector block 104 may be configured to generate the fault signal based on the timer reaching the first time duration which indicates that no change has been determined in the first time period.

In another example, the detector block 104 may determine a condition of when there are more state changes in the analogue signal or signature signal than expected, which may be a sign of a fault. Thus, the predetermined number of changes may comprise at least one and the detector block 104 is configured to generate the fault signal based on when there are greater than the predetermined number of changes in the input signal occurring over the first time duration.

In another example, the detector block 104 may determine a condition of when there are fewer state changes in the analogue signal or signature signal than expected, which may be a sign of a fault. Thus, the predetermined number of changes may comprise at least two and the detector block may be configured to generate the fault signal when there are less than the predetermined number of changes in the input signal occurring over the first time duration.

It will be appreciated that any of the conditions disclosed herein, that the detector block 104 uses to prompt the generation of the fault signal, can be combined in a single embodiment. For example, the detector block 104 may be configured to generate the fault signal based on when there is an absence of changes in the input signal persisting for the first time duration and also based on when there are greater than a second predetermined number of changes in the input signal occurring over a second time duration. Thus, the predetermined number of changes and/or the time duration may be different (or the same) for each of the conditions that the detector block 104 uses to determine when to generate the fault signal.

In another example, the detector block 104 is configured to generate the fault signal indicative of the determination of the occurrence of a fault based on no input signal 105 being received. Thus, the detector block 104 may determine when there are more state changes in the analogue signal or signature signal than expected and also when there is no input signal 105 being received, and the fault signal is generated based on either condition being satisfied.

In some examples, when the detector block uses multiple conditions, the detector block 104 may be configured to generate a fault signal that carries information that distinguishes between the conditions that prompted the generation of the fault signal. Therefore, any further action that may be taken by the test circuit 100 or other circuit that receives the fault signal can be customized. In an example, a fault signal indicative of the absence of the input signal 105 may prompt the generation of signalling for the characterisation block 107 prior to signalling for the further circuit 101. Thus, the correct functioning of the test circuit 100 may be verified before taking further action regarding the operation of the further circuit 101.

In another example, the detector block 104 is configured to generate the fault signal indicative of the determination of the occurrence of a fault in the further circuit based on the condition of a magnitude of the input signal 105 being greater than a predetermined maximum threshold value or less than a predetermined minimum threshold value. In such an example, the detector block 104 may include a comparator, which may be in addition to the timer, to determine when the magnitude of the input signal 105 exceeds or falls under a plausible threshold value.

In some examples, the test circuit 100 provides the fault signal 108 as its output. However, in other examples, the test circuit 100 may further comprise an action block 110 configured to generate signalling to control the operation of the further circuit 101 based on generation of the fault signal. Thus, the action block 110 may comprise logic to generate the signalling to mitigate the fault based on generation of the fault signal. The signalling may cause the further circuit 101 to shut down, enter a protective "limp" mode or any other appropriate action. In some examples, as mentioned above, the fault signal may carry information indicative of the condition detected by the detector block 104 (in examples where a plurality of different conditions are detected). Thus, the action block 110 may be configured to take different action based on the condition that triggered the fault signal.

In the example of Figure 1, the further circuit 101 is shown on a first integrated circuit and the test circuit 100 is shown on a second integrated circuit. Figure 1 also shows that part of the test circuit 100, namely the characterization block 107, may be provided on the first integrated circuit with the further circuit 101. However, in other examples the characterization block 107 may be provided on the second integrated circuit with the detector block 104.

Thus, the test circuit 100 may be provided as a separate integrated circuit for coupling with a further circuit 101. In other examples, there may be provided a system comprising the further circuit 101 and the test circuit 100, wherein the test circuit comprises a built-in-self-test, BIST, circuit for the further circuit.

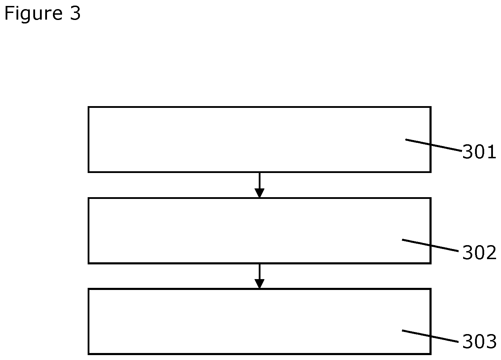

Figure 3 shows an example method of determining the occurrence of a potential fault in a further circuit by a test circuit, the method comprising:
receiving 301 an input signal at least based on an analogue signal output from the further circuit during operation of the further circuit;
determining 302 the occurrence of changes in the input signal, and
generating 303 a fault signal indicative of a determination of the occurrence of a fault in the further circuit based at least on a predetermined number of the determined changes in the input signal occurring over a first time duration.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A test circuit for detecting faults occurring in a further circuit, the test circuit comprising:
a detector block configured to:
receive an input signal at least based on an analogue signal output from the further circuit during operation of the further circuit;
determine the occurrence of changes in the input signal, and
generate a fault signal indicative of a determination of the occurrence of a fault in the further circuit based at least on a predetermined number of the determined changes in the input signal occurring over a first time duration.

2. The test circuit of claim 1, wherein the test circuit is configured to receive the analogue signal output from one of: a sensor of the further circuit; an actuator of the further circuit; a switch of the further circuit.

3. The test circuit of claim 1 or claim 2, wherein the test circuit includes:
a characterisation block configured to receive the analogue signal from the further circuit and, based on the analogue signal, generate a signature signal, wherein the signature signal is indicative of changes in the analogue signal that meet one or more criteria, wherein the input signal to the detector block comprises said signature signal.

4. The test circuit of any preceding claim, wherein the predetermined number comprises zero and the detector block is configured to generate the fault signal based on when there is an absence of changes in the input signal persisting for the first time duration.

5. The test circuit of claim 4, wherein the detector block includes a timer to measure the first time duration and wherein the timer is reset based on each determination of the occurrence of the change in the input signal.

6. The test circuit of any one of claims 1 to 3, wherein the predetermined number comprises at least one and the detector block is configured to generate the fault signal based on when there are greater than the predetermined number of changes in the input signal occurring over the first time duration.

7. The test circuit of any one of claims 1 to 3, wherein the predetermined number comprises at least two and the detector block is configured to generate the fault signal when there are less than the predetermined number of changes in the input signal occurring over the first time duration.

8. The test circuit of any preceding claim, wherein the detector block is configured to generate the fault signal indicative of the determination of the occurrence of a fault in the further circuit based on no input signal being received.

9. The test circuit of any preceding claim, wherein the detector block is configured to generate the fault signal indicative of the determination of the occurrence of a fault in the further circuit based on a magnitude of the input signal being greater than a predetermined maximum threshold value.

10. The test circuit of any preceding claim, wherein the detector block is configured to generate the fault signal indicative of the determination of the occurrence of a fault in the further circuit based on a magnitude of the input signal being less than a predetermined minimum threshold value.

11. The test circuit of any preceding claim, further comprising an action block configured to generate signalling to control the operation of the further circuit based on generation of the fault signal.

12. The test circuit of any preceding claim, wherein the first time duration comprises a sliding time window.

13. The test circuit of any preceding claim, wherein the first time duration is measured from points in time defined by the operation of the further circuit.

14. A system comprising the further circuit and the test circuit of any preceding claim, wherein the test circuit comprises a built-in-self-test, BIST, circuit for the further circuit.

15. A method of determining the occurrence of a fault in a further circuit by a test circuit, the method comprising:
receiving an input signal at least based on an analogue signal output from the further circuit during operation of the further circuit;
determining the occurrence of changes in the input signal, and
generating a fault signal indicative of a determination of the occurrence of a fault in the further circuit based at least on a predetermined number of the determined changes in the input signal occurring over a first time duration.
